# EUROPEAN PATENT APPLICATION

(11) **EP 4 626 147 A1**
(43) Date of publication of application: **01.10.2025**
(21) Application number: 25158785.3
(22) Date of filing: 19.02.2025
(51) Int. Cl.: H05K 1/02, H01L 23/538, H01L 23/64, H02M 7/00, H05K 1/18

(54) **INVERTER DEVICE**

(30) Priority: 27.03.2024 JP 2024052404
(71) Applicant: MAZDA MOTOR CORPORATION, Hiroshima 730-8670 (JP)
(72) Inventor: FURUKAWA, Akihiro, Aki-gun, Hiroshima, 730-8670 (JP); TOGASHI, Shigenori, Kanagawa, 252-0243 (JP)
(74) Representative: Thoma, Michael

(57) **Abstract**

An inverter device includes: an interconnect substrate having a first interconnect layer and a second interconnect layer; and a plurality of transistors arranged in a middle layer, each having a source region and a drain region surrounding the source region on one face. The plurality of transistors include a first transistor placed with the one face facing the first interconnect layer and having a drain connected to a first interconnect in the first interconnect layer and a source connected to a second interconnect in the first interconnect layer. The first interconnect overlaps the drain region of the first transistor in planar view, and the second interconnect extends from the opening of the first interconnect to the position overlapping the source region of the first transistor in planar view.

## Description

### BACKGROUND

The technology disclosed herein belongs to a technical field related to an inverter device.

As inverter devices are becoming increasingly higher in power output with the improvement in power density, a technology for reducing the inductance of the inverter devices is being required. Also, with the increase in power output, it is being required to enhance the heat dissipation performance of the inverter devices.

Japanese Unexamined Patent Publication No. 2007-234690 (Patent Document 1) describes a technology using flip mounting from the standpoint of improving heat dissipation by minimizing the length of a current loop. Specifically, in Patent Document 1, in high-side IGBT and FWD chips, a collector electrode and a cathode electrode, which are chip back electrodes, are soldered to a power supply pattern on an insulating substrate. On the other hand, in low-side IGBT and FWD chips, an emitter electrode and an anode electrode, which are chip surface electrodes, are soldered to a ground pattern on the insulating substrate, whereby flip mounting is realized.

Japanese Unexamined Patent Publication No. 2020-150096 (Patent Document 2) describes a technology of manufacturing a printed wiring board with electronic components embedded therein.

In conventional inverter devices, transistors are mounted on the surface of a substrate. In the case of embedding transistors constituting an inverter device in a substrate, as in Patent Document 2, however, heat dissipation measures have not been sufficiently examined, leaving room for examination.

In view of the above problem, an objective of the technology disclosed herein is enhancing the heat dissipation performance of an inverter device that uses an interconnect substrate configured to allow components to be embedded therein.

### SUMMARY

According to one mode of the technology disclosed herein, an inverter device includes: an interconnect substrate having a first interconnect layer and a second interconnect layer; and a plurality of transistors each having a source region and a drain region surrounding the source region on one face, arranged in a middle layer between the first interconnect layer and the second interconnect layer, wherein the plurality of transistors include a first transistor placed with the one face facing the first interconnect layer and having a drain connected to a first interconnect in the first interconnect layer and a source connected to a second interconnect in the first interconnect layer, the first interconnect overlaps the drain region of the first transistor in a C-shape and has a recess recessed from an opening of the C-shape to the source region of the first transistor in planar view, and the second interconnect has a protrusion protruding into the recess and overlapping the source region of the first transistor in planar view.

Having the above configuration, electrical conductive performance and thermal conductive performance can be enhanced. Specifically, the difference in heat dissipation resistance relates to the contact area. In relation to this, while the source and drain of each transistor are in contact with each other over the entire face, the sources and the interconnects are connected via a plurality of vias. Since ease of heat conduction (heat conductive performance) is proportional to the contact area, it has a relationship of "drain (large in contact area) > source (small in contact area)." Therefore, by providing the first interconnect so as to overlap the drain region of the first transistor in a C-shape, the contact area of the drain to which heat is easily conducted can be increased, and therefore thermal conductive performance can be enhanced. Also, since the contact area of the drain increases, electrical resistance can be reduced, and therefore electrical conductive performance can be enhanced. Moreover, the recess is provided in the first interconnect, and the second interconnect has the protrusion overlapping the source region of the first transistor. Therefore, while the electrical conductive performance and the thermal conductive performance are enhanced, it is possible to form the first interconnect connected to the drain of the first transistor and the second interconnect connected to the source of the first transistor in the same interconnect layer.

As described above, according to the technology disclosed herein, the heat dissipation performance of an inverter device can be enhanced.

### BRIEF DESCRIPTION OF THE DRAWINGS

FIG. 1 is a circuit diagram of an inverter device.
FIG. 2 is a sectional side view showing a configuration example of an inverter device of the first embodiment.
FIG. 3 is a plan view of the inverter device of the first embodiment as viewed from above a second interconnect layer.
FIG. 4 is a bottom view of the inverter device of the first embodiment as viewed from below a fifth interconnect layer.
FIG. 5 is an alteration of the bottom view of the inverter device of the first embodiment as viewed from below the fifth interconnect layer.
FIG. 6 is a comparative example of the bottom view of the inverter device of the first embodiment as viewed from below the fifth interconnect layer.
FIG. 7 is a sectional side view, equivalent of FIG. 2, showing an alteration of the inverter device of the first embodiment.
FIG. 8 is a plan view of an inverter device of the second embodiment.
FIG. 9 is a plan view of one phase of the inverter device of the second embodiment as viewed from above a second interconnect layer.
FIG. 10 is a bottom view of one phase of the inverter device of the second embodiment as viewed from below a fifth interconnect layer.
FIG. 11 is a cross-sectional view taken along line XI-XI in FIG. 9.
FIG. 12 is a cross-sectional view taken along line XII-XII in FIG. 9.

### DETAILED DESCRIPTION

Illustrative embodiments will be described hereinafter with reference to the accompanying drawings. Note that the following description of the embodiments is merely illustrative essentially and will be made centering on the configuration related to the subject matter of the technology disclosed. Also, although technical elements different from the subject matter of the technology disclosed may be illustrated or described briefly, or description of such elements may be omitted, this will never be intended to limit the scope of the technology disclosed. In the present disclosure, the term "connection" is used as a concept broadly encompassing the state of being electrically connected. For example, the term "connection" includes, not only the case of direct connection between elements, but also the case of indirect connection between elements through a via or the like.

### <First Embodiment>

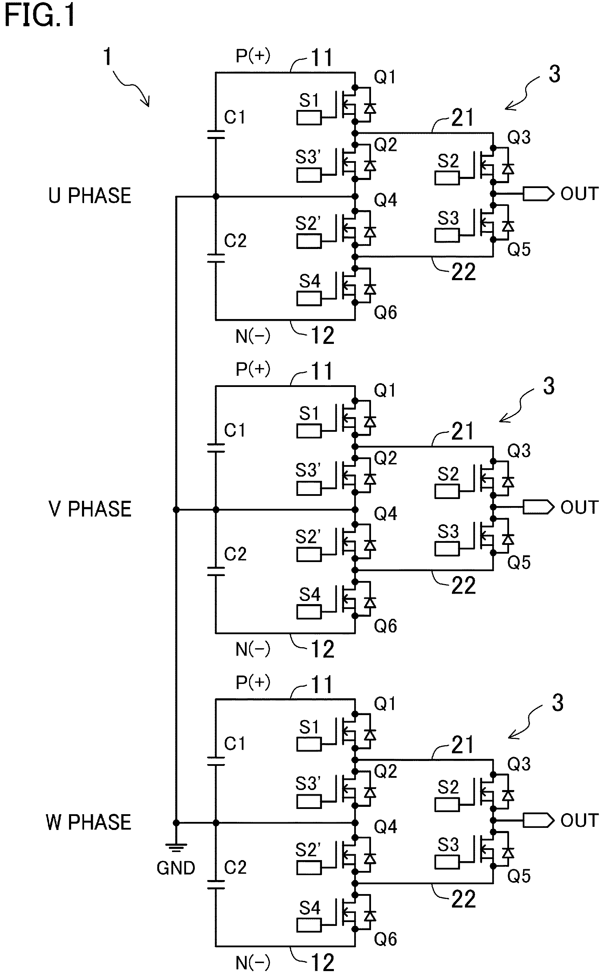

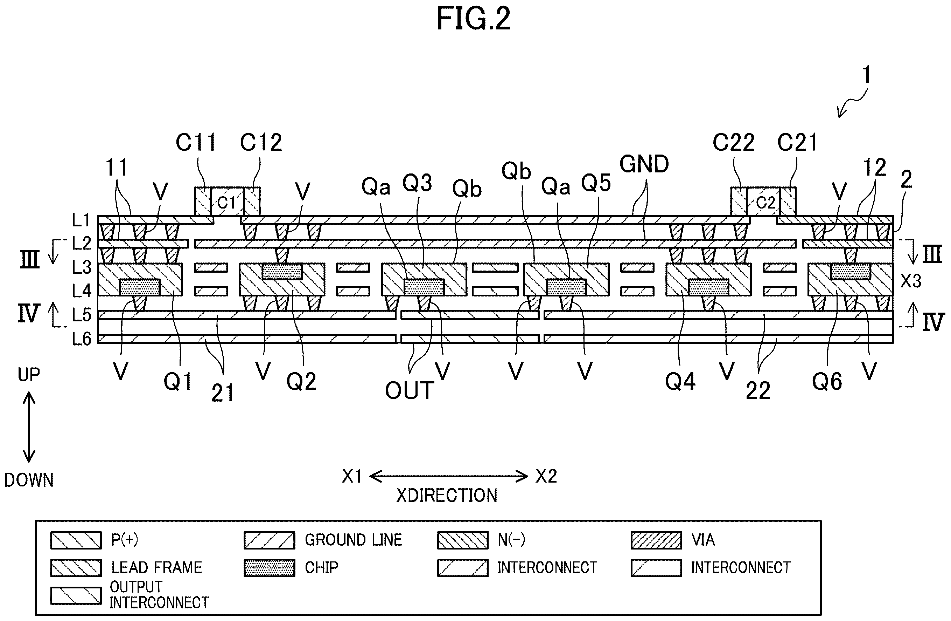

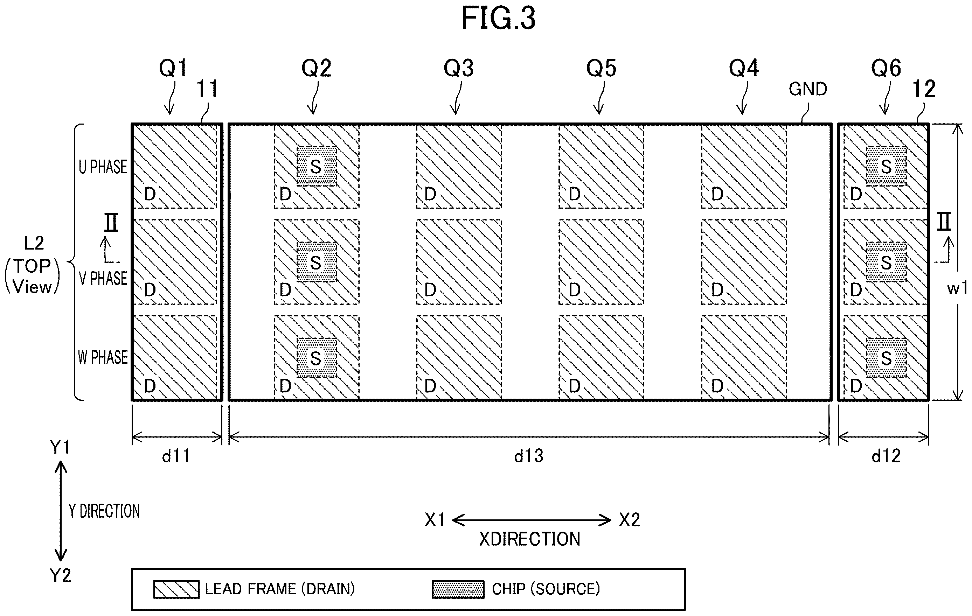

FIG. 1 is a circuit diagram of an inverter device according to this embodiment. FIG. 2 is a sectional side view (e.g., a cross-sectional view taken along line II-II in FIG. 3) showing a configuration of the inverter device.

As shown in FIG. 1, in this example, the inverter device 1 is a 3-level inverter that outputs AC of three phases (U phase, V phase, and W phase) from a DC power supply such as a battery (not shown). The uses of the inverter device 1 are not specifically limited, but include driving of automobiles and actuation of engines (e.g., an integrated starter generator (ISG)), for example.

As shown in FIGS. 1 and 2, the inverter device 1 includes an interconnect substrate 2 and inverter circuits 3 of three phases (U phase, V phase, and W phase) mounted in the interconnect substrate 2. The inverter circuit 3 of each phase includes transistors Q1 to Q6, a first capacitor C1, and a second capacitor C2. Note that, in the following description, the transistors Q1 to Q6 may be collectively called the "transistors Q" when described with no distinction.

### -Interconnect Substrate-

The interconnect substrate 2 is a multi-layer interconnect substrate (e.g., a printed board) having six interconnect layers, for example. For convenience of description, as shown in FIG. 2, the thickness direction of the interconnect substrate 2 is defined as the up/down direction, and the interconnect layer (first interconnect layer) having the principal surface (uppermost face) on which the first capacitor C1 and the second capacitor C2 are placed is called an interconnect layer L1. From the interconnect layer L1 downward, interconnect layers L2 to L6 (second to sixth interconnect layers) are formed in this order with an insulating layer (e.g., a layer formed of resin) interposed between every adjacent interconnect layers. From the standpoint of improving heat dissipation performance, it is preferable to use a glass epoxy resin or a high thermal conductive resin for the insulating layer between the interconnect layer L5 and the interconnect layer L6.

### -Capacitor-

The first capacitor C1 is provided between a first power line 11 to which a positive power supply voltage P(+) is supplied from a battery (not shown) or the like and a ground line GND that is grounded. The second capacitor C2 is provided between the ground line GND and a second power line 12 to which a negative power supply voltage N(-) is supplied from a battery (not shown) or the like.

### -Transistor-

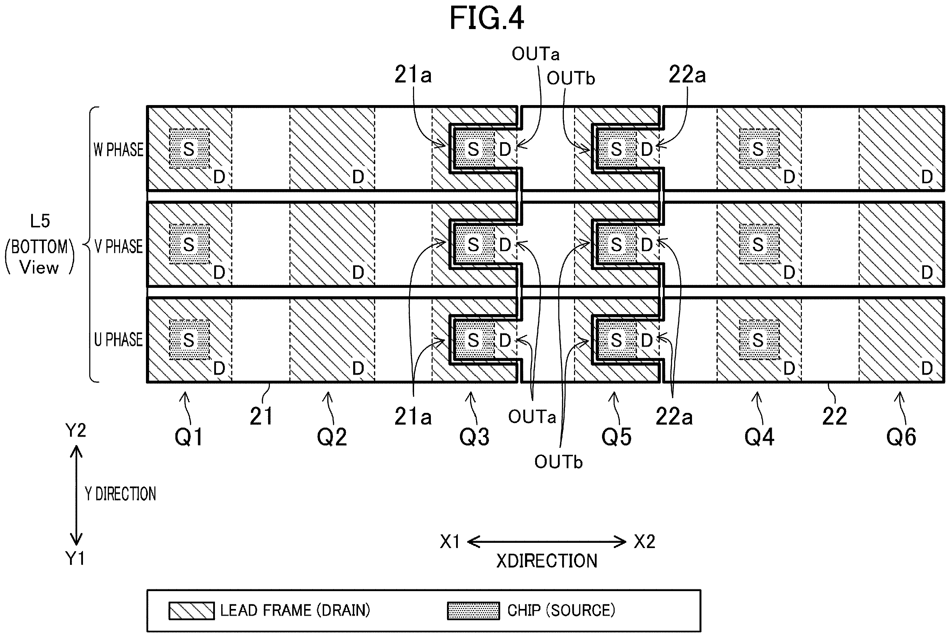

FIG. 3 is a plan view of the inverter device 1 as viewed from above the interconnect layer L2, and FIG. 4 is a bottom view of the inverter device 1 as viewed from below the interconnect layer L5. In FIGS. 3 and 4, the positions of the transistors Q1 to Q6 are indicated by the broken lines. Note that the X direction and the Y direction are defined as directions perpendicular to the up/down direction and also directions orthogonal to each other. Also, in the following description, out of the X direction, the leftward direction in FIG. 3 may be called the X1 direction and the rightward direction in FIG. 3 called the X2 direction. Also, out of the Y direction, the upward direction in FIG. 3 may be called the Y1 direction and the downward direction in FIG. 3 called the Y2 direction. Note that the up/down direction, the X direction, and the Y direction are directions set for convenience of description, which are mere illustrations introduced for brevity of the description and by no means intended to limit the structure of the inverter device 1.

As shown in FIGS. 2 to 4, the transistors Q1 to Q6 of U phase, V phase, and W phase are placed in a middle layer between the interconnect layer L2 and the interconnect layer L5. In this example, the interconnect layer L3, the interconnect layer L4, and an insulating layer X3 between L3 and L4 correspond to the "middle layer." Specifically, the transistors Q1 to Q6 of three phases are arranged in the X-Y directions in the middle layer in planar view. More specifically, the transistors Q1 to Q6 of each phase are arranged in the X2 direction in the order of Q1, Q2, Q3, Q5, Q4, and Q6 in the middle layer. Moreover, the set of the transistors Q1 to Q6 of U phase, the set of the transistors Q1 to Q6 of V phase, and the set of the transistors Q1 to Q6 of W phase are arranged in the Y2 direction in the order of U phase, V phase, and W phase. That is, in the inverter circuit 3 of each phase, the transistors Q1 to Q6 are arranged linearly in the X direction in planar view. Also, the inverter circuits 3 of the three phases (U phase, V phase, and W phase) are arranged in the Y direction in planar view. Specifically, the transistor Q1 of U phase, the transistor Q1 of V phase, and the transistor Q1 of W phase are arranged linearly in the Y direction. This relationship also applies to the respective transistors Q2 to Q6 of the phases (U phase, V phase, and W phase).

The transistors Q are each an n-type power MOSFET of a vertical structure, and in this example, constituted by a semiconductor chip Qa (simply indicated as a "chip" in the figures) and a lead frame Qb. The semiconductor chip Qa has a source on one face and a drain on the other face. The lead frame Qb, made of copper, for example, is formed to have a U-shape in sectional side view (see FIG. 2) to cover the other face (drain) of the semiconductor chip Qa, and connected to the drain of the semiconductor chip Qa. That is, the lead frame Qb and the drain of the semiconductor chip Qa have the same potential.

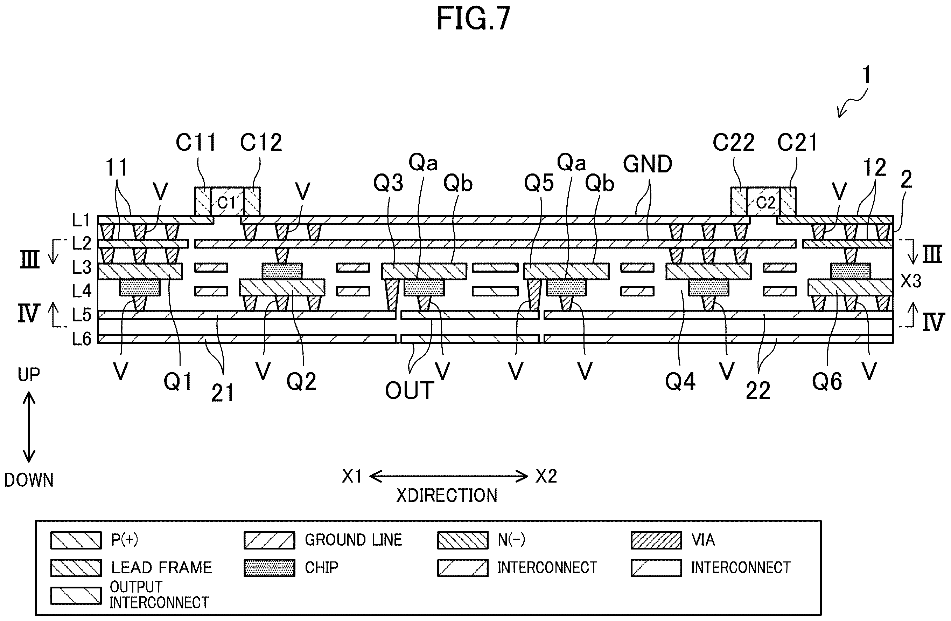

In other words, the transistor Q has a source region S in which a source terminal is provided and a drain region D in which a drain terminal is provided to surround the source region S on one face, and has the drain region D entirely on the other face. In this example, the source region S has a rectangular shape and the drain region D is provided to surround the source region S as a rectangular frame. However, the shape of the source region S is not limited to the rectangle, and the drain region D is not necessarily required to surround the source region S entirely, but may be partly discontinued. In the following description, the one face is called the "source-drain face" and the other face is called the "drain face." Note that the "one face (source-drain face)" and the "other face (drain face)" as used herein are not limited to be flat faces. Specifically, for example, as will be described with reference to FIG. 7 later, there may be a step (vertical step in FIG. 7) on the source-drain face between the face on which the source is provided and the face on which the drain is provided. As another example, part of the face on which the source is provided and/or the face on which the drain is provided may be inflated or dented. Note that the gate of the transistor Q is formed on the source-drain face of the semiconductor chip Qa although illustration is omitted because it falls outside the subject matter of the technology disclosed.

Note that the source and drain of each transistor Q and interconnects formed in the interconnect layers L2 and L5 are connected through a plurality of vias V and the lead frame Qb. For convenience of description, however, description of the connections through the vias V and the lead frame Qb may be omitted hereinafter. This also applies to connections of interconnects between the interconnect layers: i.e., illustration and/or description of connections through vias V and lead frames Qb may be omitted. Note also that, in FIG. 2, for easy understanding of the drawing, common hatching is given to interconnects to which a common signal or voltage is applied. In other words, in FIG. 2, interconnects under common hatching are mutually connected through vias and the like (whether shown or not shown).

The transistors Q1 to Q6 will be described individually hereinafter. Since the configurations of the transistors Q1 to Q6 are the same among U phase, V phase, and W phase, description here will be made for one phase only.

As shown in FIG. 2, the transistor Q1 is placed with the source-drain face facing the interconnect layer L5 and the drain face facing the interconnect layer L2, that is, positioned with the drain face facing upward. In the transistor Q1, the source terminal (hereinafter simply called the "source") is connected to an interconnect 21 in the interconnect layer L5, and the drain terminal (hereinafter simply called the "drain") on the drain face is connected to the first power line 11 in the interconnect layer L2. The "terminal" is used herein to mean an inlet/outlet of a current, and its specific form and mode are not specifically limited.

The transistor Q2 is placed with the drain face facing the interconnect layer L5 and the source-drain face facing the interconnect layer L2, that is, positioned with the source-drain face facing upward. In the transistor Q2, the source is connected to the ground line GND in the interconnect layer L2, and the drain on the drain face is connected to the interconnect 21 in the interconnect layer L5.

The transistor Q3 is placed with the source-drain face facing the interconnect layer L5 and the drain face facing the interconnect layer L2, that is, positioned with the drain face facing upward. In the transistor Q3, the source is connected to an output interconnect OUT in the interconnect layer L5, and the drain on the source-drain face is connected to the interconnect 21 in the interconnect layer L5. Specifically, as shown in FIG. 4, the interconnect 21 overlaps the drain region on the source-drain face of the transistor Q3 in a C-shape and is connected to the drain of the transistor Q3 in the overlap portion in planar view. The output interconnect OUT extends from the opening formed in the C-shaped portion of the interconnect 21 to the position overlapping the source region of the transistor Q3 and is connected to the source of the transistor Q3 at the overlap position in planar view. In other words, the interconnect 21 overlaps the drain region D on the source-drain face of the transistor Q3 in a C-shape and has a recess 21a recessed from the opening of the C-shape to the source region of the transistor Q3 in planar view. The output interconnect OUT has a protrusion OUTa protruding into the recess 21a in the X1 direction and overlapping the source region S of the transistor Q3 in planar view. The output interconnect OUT is connected to the source of the transistor Q3 at the overlap position of the protrusion OUTa with the source region S of the transistor Q3.

The transistor Q5 is placed with the source-drain face facing the interconnect layer L5 and the drain face facing the interconnect layer L2, that is, positioned with the drain face facing upward. In the transistor Q5, the source is connected to an interconnect 22 in the interconnect layer L5, and the drain on the source-drain face is connected to the output interconnect OUT in the interconnect layer L5. Specifically, as shown in FIG. 4, the output interconnect OUT overlaps the drain region on the source-drain face of the transistor Q5 in a C-shape and is connected to the drain of the transistor Q5 in the overlap portion in planar view. The interconnect 22 extends from the opening formed in the C-shaped portion of the output interconnect OUT to the position overlapping the source region of the transistor Q5 in the X1 direction and is connected to the source of the transistor Q5 at the overlap position in planar view. In other words, the output interconnect OUT overlaps the drain region D on the source-drain face of the transistor Q5 in a C-shape and has a recess OUTb recessed from the opening of the C-shape to the source region of the transistor Q5 in planar view. The interconnect 22 has a protrusion 22a protruding into the recess OUTb in the X1 direction and overlapping the source region S of the transistor Q5. The interconnect 22 is connected to the source of the transistor Q5 at the overlap position of the protrusion 22a with the source region S of the transistor Q5.

The transistor Q4 is placed with the source-drain face facing the interconnect layer L5 and the drain face facing the interconnect layer L2, that is, positioned with the drain face facing upward. In the transistor Q4, the source is connected to the interconnect 22 in the interconnect layer L5, and the drain on the drain face is connected to the ground line GND in the interconnect layer L2.

The transistor Q6 is placed with the drain face facing the interconnect layer L5 and the source-drain face facing the interconnect layer L2, that is, positioned with the source-drain face facing upward. In the transistor Q6, the source is connected to the second power line 12 in the interconnect layer L2, and the drain on the drain face is connected to the interconnect 22 in the interconnect layer L5.

### -Interconnect-

The first power line 11 is connected to a terminal C11 of the first capacitor C1 in the interconnect layer L1. Also, as described above, the first power line 11 in the interconnect layer L2 and the drain of the transistor Q1 are connected to each other. That is, the first power line 11 is constituted by interconnects formed in the interconnect layer L1 and the interconnect layer L2. Although not illustrated, the interconnect in the interconnect layer L1 is formed to cover the interconnect in the interconnect layer L2 in planar view. From the standpoint of generating a current in the X2 direction in the interconnect layer L1, the first power line 11 in the interconnect layer L1 extends longer in the X2 direction than the first power line 11 in the interconnect layer L2.

The second power line 12 is connected to a terminal C21 of the second capacitor C2 in the interconnect layer L1. Also, as described above, the second power line 12 in the interconnect layer L2 and the source of the transistor Q6 are connected to each other. That is, the second power line 12 is constituted by interconnects formed in the interconnect layer L1 and the interconnect layer L2. Although not illustrated, the interconnect in the interconnect layer L1 is formed to cover the interconnect in the interconnect layer L2 in planar view. From the standpoint of generating a current in the X1 direction in the interconnect layer L1, the second power line 12 in the interconnect layer L1 extends longer in the X1 direction than the second power line 12 in the interconnect layer L2.

The ground line GND is connected to a terminal C12 of the first capacitor C1 and a terminal C22 of the second capacitor C2 in the interconnect layer L1. Also, as described above, the ground line GND in the interconnect layer L2 is connected to the source of the transistor Q2 and the drain of the transistor Q4. The ground line GND is mainly constituted by interconnects formed in the interconnect layer L1 and the interconnect layer L2, and formed to cover the transistors Q2, Q3, Q5, and Q4 in planar view. Note that the ground line GND may be provided in the interconnect layer L3 and/or the interconnect layer L4.

The interconnect 21 is constituted by interconnects formed in the interconnect layer L5 and the interconnect layer L6, and extends from the end of the transistor Q1 in the X1 direction to the drain region D on the source-drain face of the transistor Q3, for example. The interconnect 21 is an interconnect having a rectangular shape placed to cover the source region S of the transistor Q1, the drain region D of the transistor Q2, and the drain region D on the X1-direction side of the transistor Q3 in planar view for each of U phase, V phase, and W phase, for example. As described above, the interconnect 21 overlaps the drain region D on the source-drain face of the transistor Q3 in a C-shape at the end in the X2 direction in planar view. In other words, in the interconnect 21, formed is the recess 21a recessed in a rectangular shape in the X1 direction to the portion overlapping the source region S on the source-drain face of the transistor Q3 in planar view. The interconnect 21 connects the source of the transistor Q1, the drain of the transistor Q2, and the drain of the transistor Q3 to one another for each of U phase, V phase, and W phase. The interconnects 21 for U phase, V phase, and W phase are separated from one another.

The output interconnect OUT is constituted by interconnects formed in the interconnect layer L5 and the interconnect layer L6, and extends from the source region of the transistor Q3 to the drain region of the transistor Q5, for example. The output interconnect OUT is placed to cover the source region S of the transistor Q3 and the drain region D on the X1-direction side of the transistor Q5 in planar view for each of U phase, V phase, and W phase. Specifically, in the end portion of the output interconnect OUT in the X1 direction, the output interconnect OUT extends with a predetermined line width until the boundary of the transistor Q3 in the X2 direction, and then, with a line width reduced to the width of the source region S, the protrusion OUTa protruding into the recess 21a of the interconnect 21 extends to the position overlapping the source region of the transistor Q3, in planar view. Also, in the end portion of the output interconnect OUT in the X2 direction, the output interconnect OUT overlaps the drain region on the source-drain face of the transistor Q5 in a C-shape in planar view. In other words, in the output interconnect OUT, formed is the recess OUTb recessed in a rectangular shape in the X1 direction to the portion overlapping the source region S on the source-drain face of the transistor Q5 in planar view. The output interconnects OUT for U phase, V phase, and W phase are separated from one another. The output interconnect OUT connects the source of the transistor Q3 and the drain of the transistor Q5 to each other. The power of each phase of the inverter device 1 is output from the output interconnect OUT.

The interconnect 22 is constituted by interconnects formed in the interconnect layer L5 and the interconnect layer L6, and extends from the source region S of the transistor Q5 to the end of the transistor Q6 in the X2 direction, for example. The interconnect 22 is placed to cover the source region S of the transistor Q5, the source region S of the transistor Q4, and the drain region D of the transistor Q6 in planar view for each of U phase, V phase, and W phase, for example. Specifically, in the end portion of the interconnect 22 in the X1 direction, the interconnect 22 extends with a predetermined line width until the boundary of the transistor Q5 in the X2 direction, and then, with a line width reduced to the width of the source region, the protrusion 22a protruding into the recess OUTb of the output interconnect OUT extends to the position overlapping the source region of the transistor Q5, in planar view. The interconnect 22 connects the source of the transistor Q5, the source of the transistor Q4, and the drain of the transistor Q6 to one another for each of U phase, V phase, and W phase. The interconnects 22 for U phase, V phase, and W phase are separated from one another.

Although illustration is omitted, the interconnects 21 in the interconnect layer L5 and the interconnect layer L6 are the same in size and shape in planar view, and are mutually connected through vias V. This also applies to the output interconnect OUT and the interconnect 22.

### -Effects of First Embodiment-

As described above, the inverter device 1 of this embodiment includes: the interconnect substrate 2 having a first interconnect layer and a second interconnect layer; and a plurality of transistors Q arranged in the middle layer between the first interconnect layer and the second interconnect layer of the interconnect substrate 2. Each of the plurality of transistors Q has a source region S and a drain region D surrounding the source region S on one face. In this embodiment, the interconnect layer L5 corresponds to the first interconnect layer, the interconnect layer L2 corresponds to the second interconnect layer, and the source-drain face corresponds to the one face.

Further, the plurality of transistors Q include a first transistor placed with the source-drain face facing the interconnect layer L5, and having a drain connected to a first interconnect in the interconnect layer L5 and a source connected to a second interconnect in the interconnect layer L5. The first interconnect overlaps the drain region of the first transistor in a C-shape, and has a recess recessed from the opening of the C-shape to the source region of the first transistor in planar view. The second interconnect has a protrusion protruding into the recess of the first interconnect and overlapping the source region of the first transistor, in planar view.

For example, in FIG. 4, when focusing on the transistor Q3 (corresponding to the first transistor), the interconnect 21 (corresponding to the first interconnect) overlaps the drain region of the transistor Q3 in a C-shape and has the recess 21a recessed from the opening of the C-shape to the source region S of the transistor Q3, and the output interconnect OUT (corresponding to the second interconnect) has the protrusion OUTa protruding into the recess 21a of the interconnect 21 and overlapping the source region S of the transistor Q3, in planar view. The source of the transistor Q1 (corresponding to the second transistor) is connected to the interconnect 21 in the interconnect layer L5, and the drain of the transistor Q5 (corresponding to the third transistor) is connected to the output interconnect OUT in the interconnect layer L5. Also, the drain of the transistor Q2 (corresponding to the second transistor) is connected to the interconnect 21 in the interconnect layer L5.

Also, when focusing on the transistor Q5 (corresponding to the first transistor), for example, the output interconnect OUT (corresponding to the first interconnect) overlaps the drain region of the transistor Q5 in a C-shape and has the recess OUTb recessed from the opening of the C-shape to the source region S of the transistor Q5, and the interconnect 22 (corresponding to the second interconnect) has the protrusion 22a protruding into the recess OUTb of the output interconnect OUT and overlapping the source region S of the transistor Q5, in planar view. The source of the transistor Q3 (corresponding to the second transistor) is connected to the output interconnect OUT in the interconnect layer L5, and the source of the transistor Q4 (corresponding to the third transistor) is connected to the interconnect 22 in the interconnect layer L5. Also, the drain of the transistor Q6 (corresponding to the third transistor) is connected to the interconnect 22 in the interconnect layer L5.

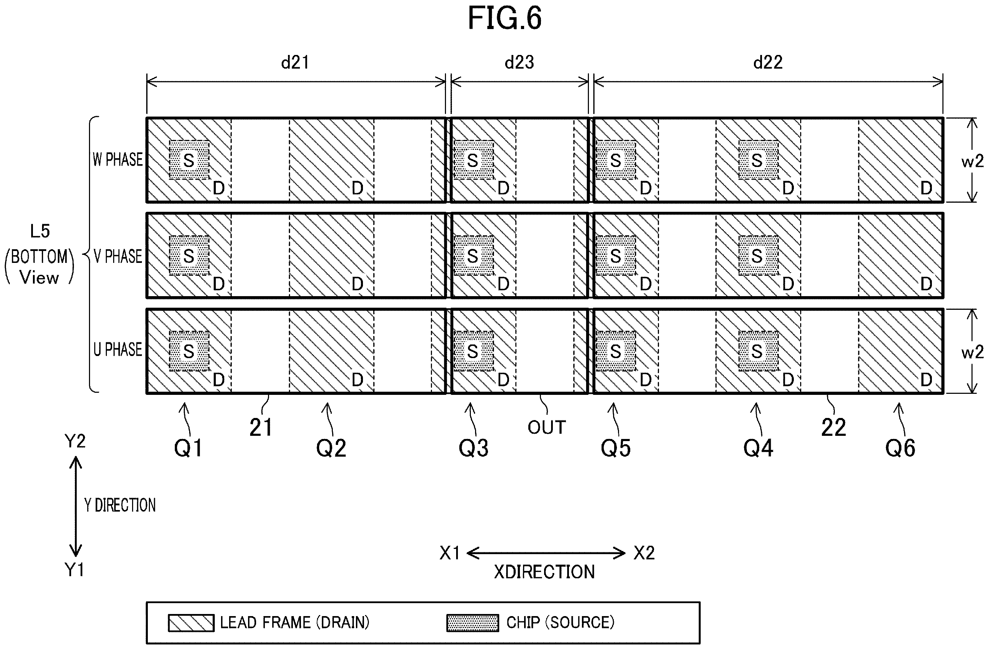

Having the above configuration, electrical conductive performance and thermal conductive performance can be enhanced. Specifically, the difference in heat dissipation resistance relates to the contact area. In relation to this, as shown in FIG. 2, while the source and drain of each transistor are in contact with each other over the entire face, the sources and the interconnects are connected through a plurality of vias. Since ease of heat conduction (heat conductive performance) is proportional to the contact area, it has a relationship of "drain (large in contact area) > source (small in contact area)." Therefore, in comparison with a comparative example shown in FIG. 6, the configuration of the present disclosure can increase the contact area of the drain to which heat is easily conducted, and therefore can enhance the thermal conductive performance. Also, since the contact area of the drain increases, electrical resistance can be reduced, and therefore electrical conductive performance can be enhanced.

### (Alteration)

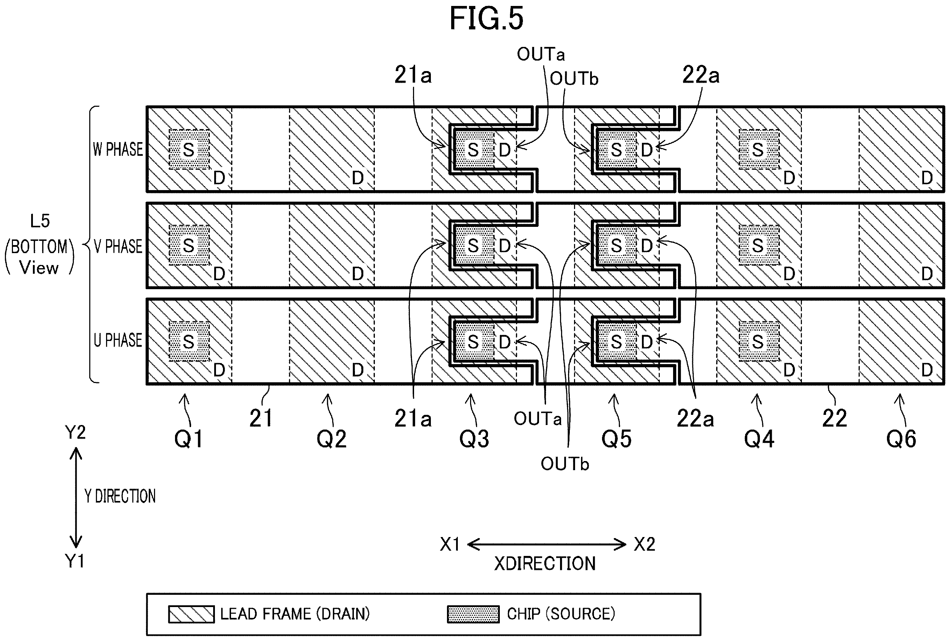

While the example in which the interconnect 21 extends in the X2 direction up to the end of the transistor Q3 in the X2 direction in the above embodiment, the configuration is not limited to this. For example, as shown in FIG. 5, the interconnect 21 may extend in the X2 direction beyond the end of the transistor Q3 in the X2 direction. In this case, also, the interconnect 21 overlaps the drain region of the transistor Q3 in a C-shape and has a recess recessed from the opening of the C-shape to the source region of the transistor Q3 in planar view. The output interconnect OUT then has a protrusion protruding into this recess and overlapping the source region of the transistor Q3, whereby effects similar to those in the above embodiment are obtained. This also applies to the relationship between the output interconnect OUT and the transistor Q5.

The technology of the present disclosure can also be applied to inverter devices having circuit configurations other than that shown in FIG. 1. For example, in the above embodiment, the transistor Q2 and the transistor Q4 may be replaced with diodes (not shown).

In the above case, a diode (first diode) replacing the transistor Q2 has a cathode connected to the interconnect 21 in the interconnect layer L5 and an anode connected to the ground line GND in the interconnect layer L2. Similarly, a diode (second diode) replacing the transistor Q4 has a cathode connected to the ground line GND in the interconnect layer L2 and an anode connected to the interconnect 22 in the interconnect layer L5. With this configuration, also, the configurations of the transistor Q3 and the transistor Q5 and the connections thereof with the interconnects are similar to those in the above embodiment, and therefore effects similar to those in the above embodiment are obtained.

Also, while the transistors Q each include the lead frame Qb having a U-shape in sectional side view as shown in FIG. 2 in the above embodiment, the shape is not limited to this. For example, as shown in FIG. 7, the lead frame Qb may have a rectangular shape longer on both sides in the X direction than the semiconductor chip Qa in sectional side view. In this case, the width in the Y direction may be made larger on both sides in the Y direction than that of the semiconductor chip Qa as in the above embodiment, or may be the same as that of the semiconductor chip Qa.

In the configuration of FIG. 7, also, the drain (lead frame Qb) on the drain-source face of the transistor Q3 and the interconnect 21 in the interconnect layer L5 are connected through a via V, for example. Similarly, the drain (lead frame Qb) on the drain-source face of the transistor Q5 and the output interconnect OUT in the interconnect layer L5 are connected through a via V. The other configuration is similar to that in FIG. 2. In the configuration of FIG. 7, also, effects similar to those in the above embodiment are obtained.

### <Second Embodiment>

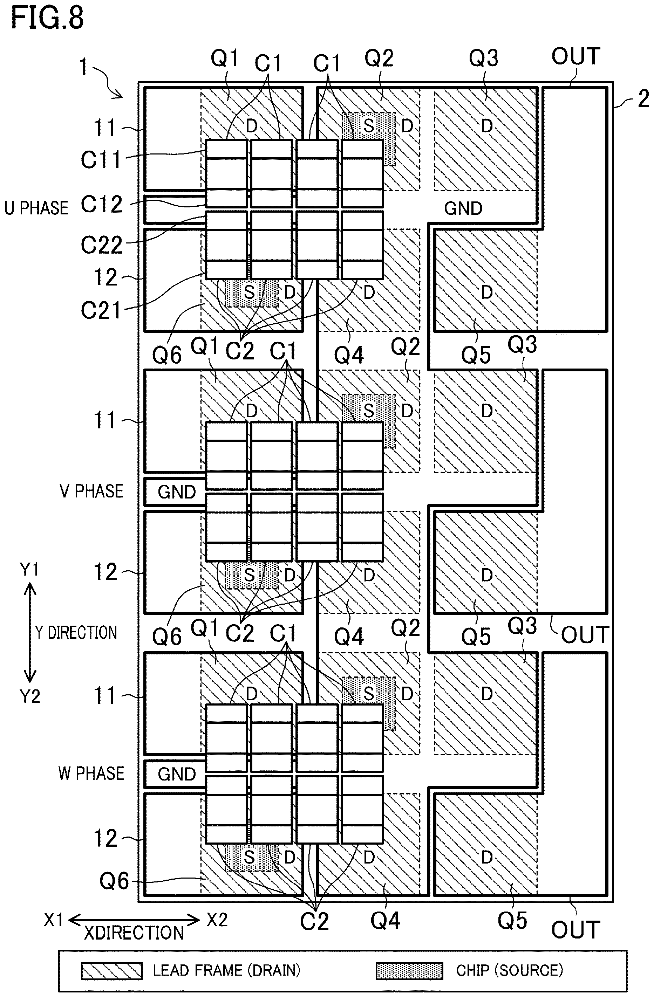

FIG. 8 is a plan view of an inverter device according to this embodiment, showing interconnects in an interconnect layer L2, where an interconnect layer L1 is omitted. In this embodiment, the circuit diagram of the inverter device 1 is the same as that of FIG. 1. Note that, in this embodiment, components corresponding to those in the first embodiment are denoted by the same reference characters. The following description will be made centering on differences from the first embodiment. Note however that there is no intention to impose the limitation that elements and the like denoted by the same reference characters in the first embodiment and the second embodiment should be the same in design parameters and process parameters. That is, the technical range of the present disclosure includes configurations in which parameters of elements and the like denoted by the same reference characters in the first and second embodiments are different between the first and second embodiments.

The configuration of the interconnect substrate is similar to that in the first embodiment, and therefore detailed description thereof is omitted here.

### -Transistor-

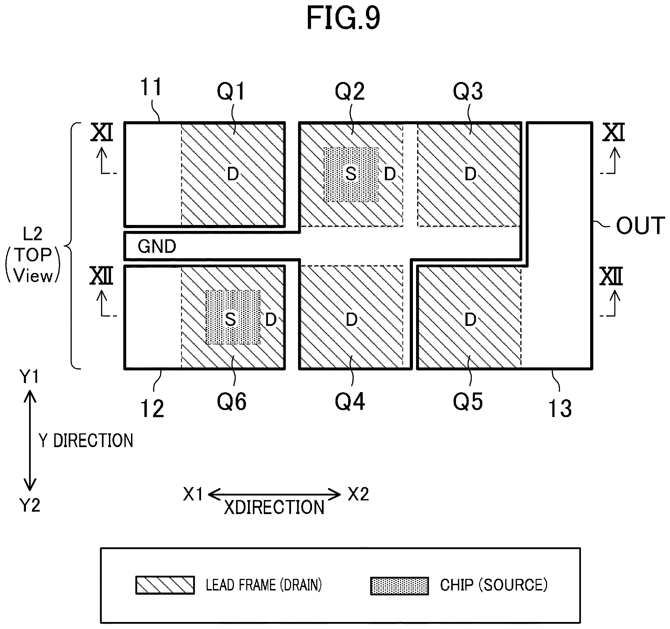

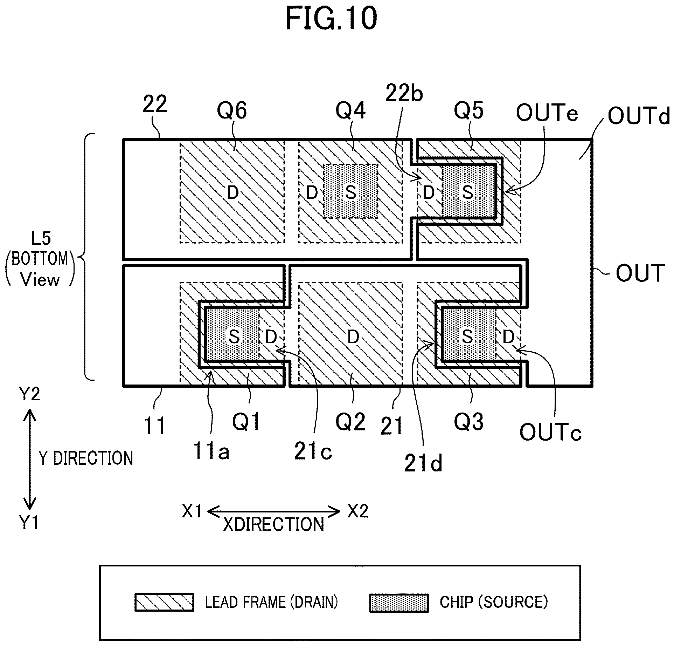

FIG. 9 is a plan view as viewed from above the interconnect layer L2, and FIG. 10 is a bottom view as viewed from below the interconnect layer L5, for one phase of the inverter device 1. In FIGS. 9 and 10, the positions of the transistors Q1 to Q6 are indicated by the broken lines. Note that the X direction and the Y direction are defined as directions perpendicular to the up/down direction and also directions orthogonal to each other. Also, in the following description, out of the X direction, the leftward direction in FIG. 9 may be called the X1 direction and the rightward direction in FIG. 9 called the X2 direction. Also, out of the Y direction, the upward direction in FIG. 9 may be called the Y1 direction and the downward direction in FIG. 9 called the Y2 direction.

The transistors Q1 to Q6 will be described individually hereinafter. Note that the structures and characteristics of the respective transistors Q (Q1 to Q6) are similar to those in the first embodiment, and therefore detailed description thereof is omitted here.

As shown in FIGS. 9 to 12, the transistors Q1 to Q6 of three phases are placed in the middle layer between the interconnect layer L2 and the interconnect layer L5. That is, the transistors Q1 to Q6 of three phases are arranged in the X-Y directions in planar view in the middle layer. Note that, since the configurations of the transistors Q1 to Q6 are the same among U phase, V phase, and W phase, description here will be made for one phase only.

The transistor Q1 is placed with the drain face facing the interconnect layer L2 and the source-drain face facing the interconnect layer L5, that is, positioned with the drain face facing upward. In the transistor Q1, the drain on the drain face is connected to the first power line 11 in the interconnect layer L2, and the source is connected to the interconnect 21 in the interconnect layer L5.

The transistor Q6, located on the side of the transistor Q1 in the Y2 direction, is placed with the source-drain face facing the interconnect layer L2 and the drain face facing the interconnect layer L5, that is, positioned with the source-drain face facing upward. In the transistor Q6, the source is connected to the second power line 12 in the interconnect layer L2, and the drain on the drain face is connected to the interconnect 22 in the interconnect layer L5.

The transistor Q2, located on the side of the transistor Q1 in the X2 direction, is placed with the source-drain face facing the interconnect layer L2 and the drain face facing the interconnect layer L5, that is, positioned with the source-drain face facing upward. In the transistor Q2, the source is connected to the ground line GND in the interconnect layer L2, and the drain on the drain face is connected to the interconnect 21 in the interconnect layer L5.

The transistor Q4, located on the side of the transistor Q2 in the Y2 direction and on the side of the transistor Q6 in the X2 direction, is placed with the drain face facing the interconnect layer L2 and the source-drain face facing the interconnect layer L5, that is, positioned with the drain face facing upward. In the transistor Q4, the source is connected to the interconnect 22 in the interconnect layer L5, and the drain on the drain face is connected to the ground line GND in the interconnect layer L2.

The transistor Q3, located on the side of the transistor Q2 in the X2 direction, is placed with the drain face facing the interconnect layer L2 and the source-drain face facing the interconnect layer L5, that is, positioned with the drain face facing upward. In the transistor Q3, the source is connected to the output interconnect OUT in the interconnect layer L5, and the drain on the X1-direction side of the source-drain face is connected to the interconnect 21 in the interconnect layer L5.

The transistor Q5, located on the side of the transistor Q3 in the Y2 direction and on the side of the transistor Q4 in the X2 direction, is placed with the drain face facing the interconnect layer L2 and the source-drain face facing the interconnect layer L5, that is, positioned with the drain face facing upward. In the transistor Q5, the source is connected to the interconnect 22 in the interconnect layer L5, the drain on the X2-direction side of the source-drain face is connected to the output interconnect OUT in the interconnect layer L5, and the drain on the drain face is connected to the output interconnect OUT in the interconnect layer L2.

### -Capacitor-

The first capacitor C1 is provided between the first power line 11 to which a positive power supply voltage P(+) is supplied from a battery (not shown) or the like and the ground line GND that is grounded. The second capacitor C2 is provided between the ground line GND and the second power line 12 to which a negative power supply voltage N(-) is supplied from a battery (not shown) or the like.

Specifically, the first capacitor C1 and the second capacitor C2 are mounted on the surface of the interconnect layer L1. In the interconnect layer L1, the ground line GND is placed between the first power line 11 provided at the position overlapping the transistor Q1 and the second power line 12 provided at the position overlapping the transistor Q6 in planar view. The first capacitor C1 is placed so that the terminal C11 overlaps the first power line 11 and the terminal C12 overlaps the ground line GND in planar view. In the interconnect layer L1, the terminal C11 and the first power line 11 are mutually connected, and the terminal C12 and the ground line GND are mutually connected. The second capacitor C2 is placed so that the terminal C21 overlaps the second power line 12 and the terminal C22 overlaps the ground line GND in planar view. In the interconnect layer L1, the terminal C21 and the second power line 12 are mutually connected, and the terminal C22 and the ground line GND are mutually connected.

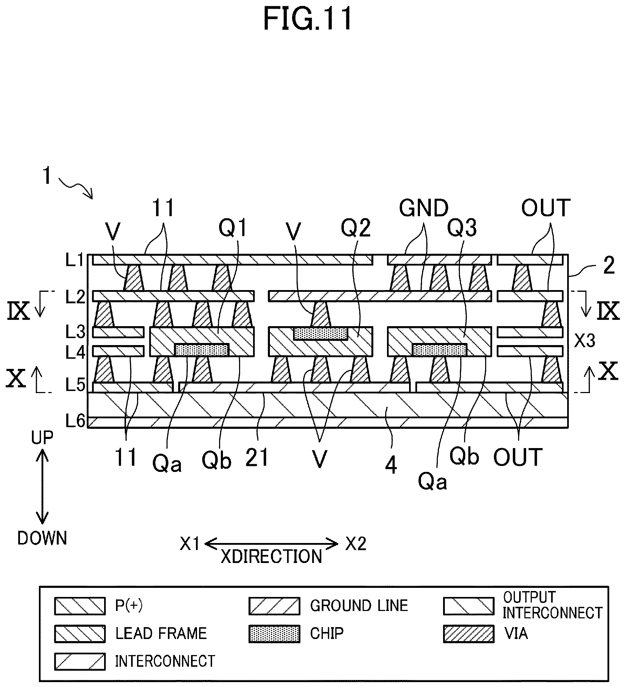

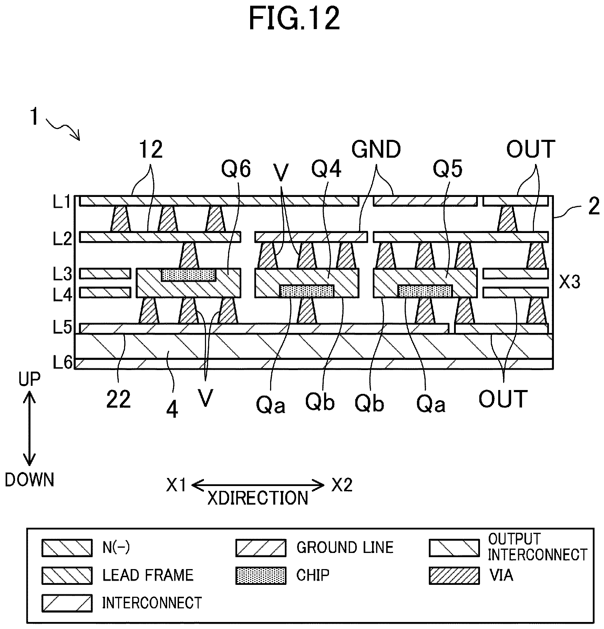

Moreover, in this embodiment, as also shown in FIGS. 11 and 12, in the interconnect layer L1, the first power line 11 extends from the position overlapping the transistor Q1 to a position overlapping the transistor Q2 in the X2 direction, and the second power line 12 extends to a position overlapping the transistor Q4 in the X2 direction. Also, in the interconnect layer L1, the ground line GND extends in the X2 direction to the space between the first power line 11 provided at the position overlapping the transistor Q2 and the second power line 12 provided at the position overlapping the transistor Q4 in planar view. Part of the first capacitor C1 is placed so that the terminal C11 overlaps the first power line 11 at the position overlapping the transistor Q2 and the terminal C12 overlaps the ground line GND provided in the Y2 direction with respect to the transistor Q2 in planar view, and these terminals and the lines are respectively connected. Similarly, part of the second capacitor C2 is placed so that the terminal C21 overlaps the second power line 12 at the position overlapping the transistor Q4 and the terminal C22 overlaps the ground line GND provided in the Y1 direction with respect to the transistor Q4 in planar view, and these terminals and the lines are respectively connected. Note that, when the space for placing the first capacitor C1 and the second capacitor C2 is sufficiently secured, it is unnecessary to provide the first capacitor C1 at the position overlapping the transistor Q2 and also unnecessary to provide the second capacitor C2 at the position overlapping the transistor Q4.

### -Interconnect-

As described above, the first power line 11 is connected to the terminal C11 (see FIG. 8) of the first capacitor C1 in the interconnect layer L1. Also, the first power line 11 in the interconnect layer L2 is connected to the drain of the transistor Q1. That is, the first power line 11 is an interconnect formed in the interconnect layer L1 and the interconnect layer L2. Moreover, the first power line 11 in the interconnect layer L2 is connected to the first power line 11 in the interconnect layer L5 through vias and the like (not shown). The first power line 11 in the interconnect layer L5 is connected to the drain on the source-drain face of the transistor Q1. Specifically, as shown in the bottom view of FIG. 10, the first power line 11 is connected to the drain of the transistor Q1 in a C-shaped region in which the first power line 11 and the drain region D of the transistor Q1 overlap each other. In other words, in bottom view, the first power line 11 overlaps the drain region D on the source-drain face of the transistor Q1 in a C-shape and has a recess 11a recessed in a rectangular shape from the opening of the C-shape to the source region S of the transistor Q1 in the X1 direction.

The interconnect 21 is an interconnect formed in the interconnect layer L5, and extends from the source region S of the transistor Q1 to the drain region D of the transistor Q3, for example. The interconnect 21 connects the source of the transistor Q1, the drain of the transistor Q2, and the drain of the transistor Q3 to one another. As shown in FIG. 10, the interconnect 21 has a protrusion 21c protruding into the recess 11a of the first power line 11 in the X1 direction and overlapping the source region S of the transistor Q1 in planar view. At the position of the overlap of the protrusion 21c with the source region S of the transistor Q1, the interconnect 21 is connected to the source of the transistor Q1. Also, the interconnect 21 overlaps the drain region D on the source-drain face of the transistor Q3 in a C-shape and has a recess 21d recessed in a rectangular shape from the opening of the C-shape to the source region S of the transistor Q3 in the X1 direction in planar view.

The output interconnect OUT is an interconnect formed in the interconnect layer L5, and connects the source of the transistor Q3 and the drain of the transistor Q5 to each other. Specifically, the output interconnect OUT includes: a protrusion OUTc that protrudes into the recess 21d of the interconnect 21 in the X1 direction and overlaps the source region S of the transistor Q3; and a rectangular interconnect OUTd that is integrally and continuously formed with the protrusion OUTc and extends in the Y direction, in planar view. Further, the output interconnect OUT extends from the interconnect OUTd in the X1 direction, overlaps the drain region D on the source-drain face of the transistor Q5 in a C-shape, and has a recess OUTe recessed in a rectangular shape from the opening of the C-shape to the source region S of the transistor Q5 in the X2 direction, in planar view.

The interconnect 22 is an interconnect formed in the interconnect layer L5, and extends from the source region S of the transistor Q5 to a position beyond the end of the transistor Q6 in the X1 direction, for example. The interconnect 22 connects the source of the transistor Q5, the source of the transistor Q4, and the drain of the transistor Q6 to one another. The interconnect 22 has a protrusion 22b protruding into the recess OUTe of the output interconnect OUT in the X2 direction and overlapping the source region S of the transistor Q5 in planar view. At the position of the overlap of the protrusion 22b with the source region S of the transistor Q5, the interconnect 22 is connected to the source of the transistor Q5.

The ground line GND is connected to the terminal C12 (see FIG. 8) of the first capacitor C1 and the terminal C22 (see FIG. 8) of the second capacitor C2 in the interconnect layer L1. Also, as described above, the ground line GND in the interconnect layer L2 is connected to the source of the transistor Q2 and the drain of the transistor Q4. Moreover, as shown in FIG. 8, the ground lines GND of the inverter circuits 3 of three phases are mutually connected through a common ground line GND (corresponding to the common ground line) extending in the Y direction over the three phases. Note that, although FIG. 8 illustrates the configuration in the interconnect layer L2, a common ground line GND extending in the Y direction over the three phases may also be provided in the interconnect layer L1. For example, the common ground line may be provided to extend in the Y direction overlapping the transistor Q3 and the transistor Q5. That is, the ground lines GND in the interconnect layer L1 in FIGS. 11 and 12 may be mutually connected and extend over the inverter circuits 3 of three phases.

The second power line 12 is connected to the terminal C21 (see FIG. 8) of the second capacitor C2 in the interconnect layer L1. Also, as described above, the second power line 12 in the interconnect layer L2 is connected to the source of the transistor Q6. That is, the second power line 12 is an interconnect formed in the interconnect layer L1 and the interconnect layer L2.

### -Effects of Second Embodiment-

As described above, in this embodiment, as in the first embodiment, the inverter device 1 includes: the interconnect substrate 2 having a first interconnect layer and a second interconnect layer; and a plurality of transistors Q arranged in the middle layer between the first interconnect layer and the second interconnect layer of the interconnect substrate 2. Each of the plurality of transistors Q has a source region S and a drain region D surrounding the source region S on one face. In this embodiment, the interconnect layer L5 corresponds to the first interconnect layer, the interconnect layer L2 corresponds to the second interconnect layer, and the source-drain face corresponds to the one face.

Further, the plurality of transistors Q include a first transistor placed with the source-drain face facing the interconnect layer L5, and having a drain connected to a first interconnect in the interconnect layer L5 and a source connected to a second interconnect in the interconnect layer L5. The first interconnect overlaps the drain region of the first transistor in a C-shape, and has a recess recessed from the opening of the C-shape to the source region of the first transistor. The second interconnect has a protrusion protruding into the recess of the first interconnect and overlapping the source region of the first transistor, in planar view.

Having the above configuration, as in the first embodiment, electrical conductive performance and thermal conductive performance can be enhanced. Also, as in the first embodiment, since the contact area of the drain increases, electrical resistance can be reduced, and therefore electrical conductive performance can be enhanced.

### (Alteration)

The configuration of this embodiment can be changed as in the alteration of the first embodiment. For example, in the configuration of FIGS. 11 and 12, the lead frame Qb may have a rectangular shape longer on both sides in the X direction than the semiconductor chip Qa in sectional side view as shown in FIG. 7. In this case, also, as in the alteration (see FIG. 7) of the first embodiment, the drain (lead frame Qb) on the drain-source face of the transistor Q3 and the interconnect 21 in the interconnect layer L5 are connected through a via V, for example. Similarly, the drain (lead frame Qb) on the drain-source face of the transistor Q5 and the output interconnect OUT in the interconnect layer L5 are connected through a via V. In this case of changing the lead frame Qb, also, effects similar to those in the second embodiment are obtained.

The technology disclosed herein is very useful because the heat dissipation performance of an inverter device can be enhanced.

## Claims

1. An inverter device, comprising:
an interconnect substrate having a first interconnect layer and a second interconnect layer; and
a plurality of transistors each having a source region and a drain region surrounding the source region on one face, arranged in a middle layer between the first interconnect layer and the second interconnect layer,
wherein
the plurality of transistors include
a first transistor placed with the one face facing the first interconnect layer and having a drain connected to a first interconnect in the first interconnect layer and a source connected to a second interconnect in the first interconnect layer,
the first interconnect overlaps the drain region of the first transistor in a C-shape and has a recess recessed from an opening of the C-shape to the source region of the first transistor in planar view, and
the second interconnect has a protrusion protruding into the recess and overlapping the source region of the first transistor in planar view.

2. The inverter device of claim 1, wherein
the plurality of transistors include
a second transistor placed with the one face facing the first interconnect layer and having a source connected to the first interconnect in the first interconnect layer, and
a third transistor placed with the one face facing the first interconnect layer and having a drain connected to the second interconnect in the first interconnect layer.

3. The inverter device of claim 1, wherein
the plurality of transistors include
a second transistor having a drain formed on the other face, placed with the other face facing the first interconnect layer, the drain on the other face being connected to the first interconnect in the first interconnect layer, and
a third transistor placed with the one face facing the first interconnect layer and having a drain connected to the second interconnect in the first interconnect layer.

4. The inverter device of claim 1, wherein
the plurality of transistors include
a second transistor placed with the one face facing the first interconnect layer and having a source connected to the first interconnect in the first interconnect layer, and
a third transistor placed with the one face facing the first interconnect layer and having a source connected to the second interconnect in the first interconnect layer.

5. The inverter device of claim 1, wherein
the plurality of transistors include
a second transistor placed with the one face facing the first interconnect layer and having a source connected to the first interconnect in the first interconnect layer, and
a third transistor having a drain formed on the other face, placed with the other face facing the first interconnect layer, the drain on the other face being connected to the second interconnect in the first interconnect layer.

6. The inverter device of claim 1, wherein
the plurality of transistors include a second transistor having a drain formed on the other face, placed side by side with the first transistor with the other face facing the first interconnect layer, the drain on the other face being connected to the second interconnect in the first interconnect layer, and
a power line is connected to the first interconnect.

7. The inverter device of claim 1, wherein
the plurality of transistors include a second transistor placed with the one face facing the first interconnect layer and having a drain connected to the second interconnect in the first interconnect layer, and
a power line is connected to the first interconnect.

8. An inverter device, comprising:
an interconnect substrate having a first interconnect layer and a second interconnect layer; and
a plurality of transistors each having a source region in which a source is formed and a drain region surrounding the source region, in which a drain is formed, on one face, and a drain region in which a drain is formed on the other face, the plurality of transistors being arranged in a middle layer between the first interconnect layer and the second interconnect layer,
wherein
the plurality of transistors include
a first transistor placed with the one face facing the first interconnect layer, the source being connected to a first interconnect formed in the first interconnect layer,
a second transistor placed with the other face facing the first interconnect layer, the drain on the other face being connected to the first interconnect,
a third transistor placed with the one face facing the first interconnect layer, the source being connected to an output interconnect formed in the first interconnect layer, and the drain on the one face being connected to the first interconnect,
a fourth transistor placed with the one face facing the first interconnect layer, the source being connected to a second interconnect formed in the first interconnect layer, and the drain on the one face being connected to the output interconnect,
a fifth transistor placed with the one face facing the first interconnect layer, the source being connected to the second interconnect, and
a sixth transistor placed with the other face facing the first interconnect layer, the drain on the other face being connected to the second interconnect,
the first interconnect overlaps the drain region of the third transistor in a C-shape and has a first recess recessed from an opening of the C-shape to the source region of the third transistor in planar view,
the output interconnect has a first protrusion protruding into the first recess and overlapping the source region of the third transistor, overlaps the drain region of the fifth transistor in a C-shape, and has a second recess recessed from an opening of the C-shape to the source region of the fifth transistor, in planar view, and
the second interconnect has a second protrusion protruding into the second recess and overlapping the source region of the fifth transistor in planar view.

9. The inverter device of claim 8, wherein
the first transistor is connected to a power line at the drain on the one face,
the power line overlaps the drain region of the first transistor in a C-shape and has a third recess recessed from an opening of the C-shape to the source region of the first transistor in planar view, and
the first interconnect has a third protrusion protruding into the third recess and overlapping the source region of the first transistor in planar view.
